# EUROPÄISCHE PATENTSCHRIFT

(11) **EP 0 609 552 B1**
(45) Veröffentlichungstag und Bekanntmachung des Hinweises auf die Patenterteilung: **20.05.1998**
(21) Anmeldenummer: 93120700.5
(22) Anmeldetag: 23.12.1993
(51) Int. Cl.: H01R 13/73, H01R 13/658, H01R 13/74, H05K 9/00

(54) **Frontabschluss für elektrische Schränke, Gehäuse,Gestelle od.dgl.**
Front closure for electrical cabinets, cases, frames and the like
Fermeture frontale pour armoires électriques, supports châssis ou similaires

(30) Priorität: 02.02.1993 DE 4302876
(43) Veröffentlichungstag der Anmeldung: 10.08.1994
(73) Patentinhaber: Quante Aktiengesellschaft, 42109 Wuppertal (DE)
(72) Erfinder: Schlüter,Dieter, D-46284 Dorsten (DE); Bohle,Klaus,Dipl.-Ing., D-46238 Bottrop (DE)
(74) Vertreter: Mentzel, Norbert, Dipl.-Phys.

(56) Entgegenhaltungen:
- EP-A- 0 319 909
- US-A- 4 583 808

## Beschreibung

Die Erfindung bezieht sich auf einen Frontabschluß der im Oberbegriff des Anspruches 1 angegebenen Art. Der Frontabschluß umfaßt ein elektrisch leitendes Blech, welches zumindest L-förmig abgewinkelt ist und, durch die Knickkante voneinander getrennt, einen Frontschenkel und einen damit einstückigen Basisschenkel bildet. In Parallelabstand zum Frontschenkel verläuft eine Leiterplatte, die vorderseitig Träger von in kantenparallelen Reihen angeordneten Buchsen ist und rückseitig zugleich als Träger von Anschlußblöcken dient. Die Anschlußblöcke einerseits und die zugehörigen Buchsen andererseits sind über Leiterbahnen miteinander verbunden. Die Anschlußblöcke dienen zum Anschluß der diversen Adern von ankommenden Kabeln. Die Leiterplatten besitzen aber auch Erdbahnen, die einerseits mit an den Buchsen befindlichen Außenabschirmungen kontaktiert sind und andererseits über weitere Anschlußblöcke mit Kabel-Beidrähten elektrisch verbunden sind. Diese Beidrähte sind zur Kontaktierung des Kabelschirms der ankommenden Kabel bestimmt.

Bei dem bekannten Frontabschluß dieser Art ist bereits die mechanische Befestigung der Buchsen von ihrer elektrischen Kontaktierung getrennt. Die Befestigung erfolgt über die Leiterplatte. Der bekannte Frontabschluß besitzt des Blech abgewinkelte Lappen, die zur Schraubbefestigung der Leiterplatte dienen. Die Erdbahnen verbinden den mit dem Kabel-Beidraht versehenen Kontaktblock mit der zugehörigen Außenabschirmung der Buchse, was zu einer hohen Impedanz führt. Die äußere Abschirmung der Buchsen ist unzureichend. Im Gebrauchsfall können unterschiedliche Potentiale entstehen.

Der Erfindung liegt die Aufgabe zugrunde, einen preiswerten, leicht montierbaren Frontabschluß der im Oberbegriff des Anspruches 1 genannten Art zu entwickeln, der sich durch eine optimale Abschirmung auszeichnet. Dies wird erfindungsgemäß durch die im Kennzeichen des Anspruches 1 angeführten Maßnahmen erreicht, denen folgende besondere Bedeutung zukommt.

Durch ein U-Kontaktglied ist die äußere Abschirmung der Buchsen unmittelbar mit einer Kontaktinnenfläche des Frontschenkels in elektrischer Verbindung, der, wie bereits erwähnt wurde, einstückig mit dem Basisschenkel ausgebildet ist und zugleich auch in elektrischer Verbindung sowohl mit dem dort befindlichen Erdungspunkt als auch mit der dortigen Erdungsklemme für die Kabelschirme steht. Damit sind alle Buchsen, unabhängig von den Erdbahnen auf der Leiterplatte, über das U-Kontaktglied in elektrischer Verbindung. Darüber hinaus sind aber auch die Erdbahnen der Leiterplatte durch elektrisch leitende Abstandhalter mit der Kontaktinnenfläche des Frontschenkels in Kontakt. Dazu besitzt die Leiterplatte an ihrer Vorderseite Vorderkontaktstellen, an denen die Stirnenden der anderendig am Frontschenkel sitzenden Abstandhalter zu liegen kommen. Vorteilhaft ist es, dabei jene Erdbahnen für diese Vorderkontaktstellen zu verwenden, bei denen auf der Rückseite der Leiterplatte die Anschlußblöcke für die Kabel-Beidrähte angeordnet sind. Dadurch ist auch für eine gute niederohmige Kontaktierung der Kabel-Beidrähte untereinander gesorgt. Alle Außenabschirmungen der Buchsen befinden sich auf einem gemeinsamen Potential. Damit ermöglicht die Erfindung eine niederimpedante Durchverbindung des Kabelschirms bis zur Außenabschirmung der Buchse, von der über eingekuppelte Stecker die abgehenden Kabel angeschlossen sind, für deren gute Erdung zugleich gesorgt ist. Die Schutzhaube dient zur Abschirmung einer Hochfrequenzabstrahlung. Sie deckt alle nicht geerdeten Elemente ab.

Weitere Maßnahmen und Vorteile der Erfindung ergeben sich aus den Unteransprüchen, der nachfolgenden Beschreibung und den Zeichnungen. In den Zeichnungen ist die Erfindung in einem Ausführungsbeispiel dargestellt. Es zeigen:
- Fig. 1: die Draufsicht auf den Endbereich eines nach der Erfindung gestalteten Frontabschlusses aus zwei noch nicht aneinander befestigten Bestandteilen, von denen einer bereichsweise ausgebrochen ist,
- Fig. 2: eine geschnittene Seitenansicht durch den Frontabschluß von Fig. 1 längs der dortigen Schnittlinie II-II,
- Fig. 3 und 4: die Vorderansicht bzw. Rückansicht auf ein Teilstück einer zum Frontabschluß von Fig. 1 und 2 gehörenden Leiterplatte, die bereichsweise mit und bereichsweise ohne daran angeschlossene Bauelemente gezeigt ist,
- Fig. 5: in Vergrößerung und Explosionsdarstellung in einem der Fig. 2 entsprechenden Schnitt ein Teilstück der Leiterplatte mit zugehörigen weiteren Elementen des Frontabschlusses,
- Fig. 6,: teilweise im Ausbruch, die Seitenansicht auf einen fertig aus beiden Bestandteilen montierten Frontabschluß und
- Fig. 7: die Rückansicht eines Teilstücks des fertig montierten Frontabschlusses längs der in Fig. 6 erkennbaren Schnittlinie VII-VII.

Der Frontabschluß nach der Erfindung besteht zunächst aus einem wenigstens L-förmig abgewinkelten elektrisch leitenden Blech 10, welches einen Frontschenkel 11 und einen über die zugehörige erste Knickkante 14 damit einstückigen Basisschenkel 12 bildet. Zweckmäßigerweise ist aber das Blech 10, über diese L-Form hinaus, insgesamt U-förmig abgewinkelt, wodurch, über eine weitere Knickkante 15, ein zum Basisschenkel 12 paralleler Deckschenkel 13 entsteht. Die einander zugekehrten Innenflächen 16, 17 des Basis- und Frontschenkels 11, 12 sind wenigstens bereichsweise blank und erzeugen elektrisch leitende Kontaktflächen, die nachfolgend "Kontaktinnenflächen" benannt werden sollen. Im vorliegenden Fall erstrecken sich diese Kontaktflächen 16, 17 über die gesamten Innenflächen des Blechs 10, dessen Außenflächen lediglich mit einem Farbbelag od. dgl. versehen sind.

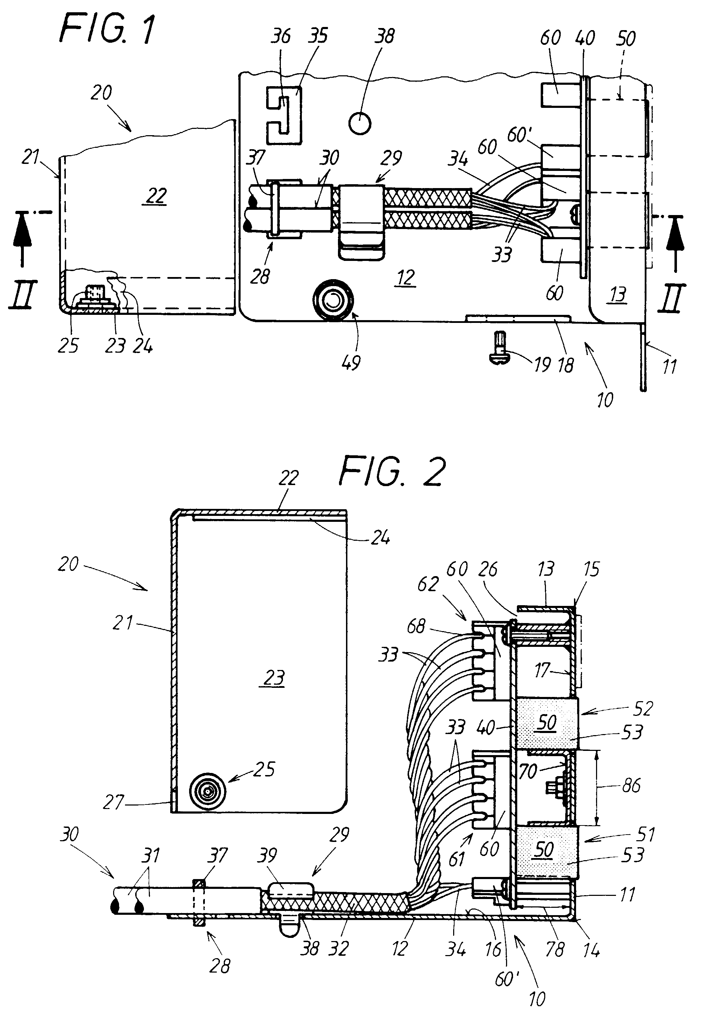

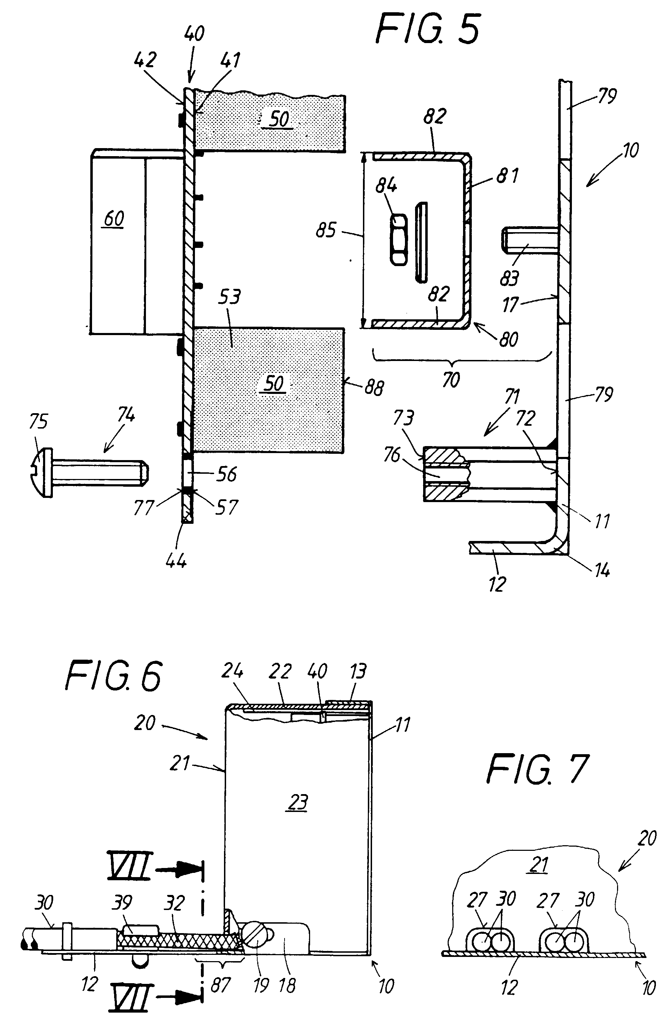

Ein weiterer Bestandteil der erfindungsgemäßen Frontplatte besteht aus einer Schutzhaube 20, die in Fig. 1 und 2 in vom Blech 10 demontierten Zustand gezeigt ist. Die Schutzhaube 20 besteht ebenfalls aus einem metallischen, elektrisch leitenden Blech, dessen diverse Wände durch Abkanten, Überlappen und Verbinden, wie Schweißen, aus einem einstückigen Blechstanzteil erzeugt sind. Die Haube 20 umfaßt eine im Montagefall im Abstand zum Frontschenkel 11 verlaufende Haubenhinterwand 21, eine gegenüber dem Basisschenkel 12 beabstandete Haubenoberwand 22 und zwei als beidendige Begrenzungen des fertig montierten Frontabschlusses dienenden Haubenseitenwänden 23. Das ist vor allem aus der montierten Lage in Fig. 6 zu erkennen. Über Randabkantungen 24 wird die Haubenoberwand 22 mit jeder der beiden zugehörigen Haubenseitenwände 23 verbunden. Außerdem ist der Basisschenkel 12 im Endbereich mit aus Fig. 1 und 6 ersichtlichen nach oben weisenden Lappen 18 versehen, denen an der Innenseite der elektrisch leitenden Haubenseitenwand 23 sitzende Gewindebüchsen 25 zugeordnet sind. Im Montagefall durchgreifen Befestigungsschrauben 19 in den Lappen befindliche Langlöcher und sind in den in der Schutzhaube 20 befindlichen Gewindebüchsen 25 einschraubbar. Wie aus dem Ausbruch in Fig. 6 erkennbar ist, untergreift im Montagefall die Haubenoberwand 22 den Deckschenkel 13 und greift dabei in eine am besten aus Fig. 2 ersichtliche freie Lücke 26 unterhalb des Deckschenkels 13 ein. Im Montagefall bildet die Schutzhaube 20 mit dem abgewinkelten Blech 10 einen in sich geschlossenen quaderförmigen Kasten, der alle im Kasteninneren befindlichen weiteren Bauteile allseitig elektrisch abschirmt.

Die Haubenhinterwand 21 ist an ihrer dem Basisschenkel 12 zugekehrten Unterkante mit einer Schar von Randausbrüchen 27 versehen, die zum Durchführen von diversen ankommenden Kabeln 30 dienen, von denen ein Paar in Fig. 1 und 2 gezeigt ist. Jedes dieser Kabel 30 ist in seinem Endbereich von seinem Außenmantel 31 befreit, wodurch zunächst der darunter befindliche übliche Kabelschirm 32 freigelegt ist. Der mit dem freiliegenden Kabelschirm 32 versehene Bereich des Kabels 30 ist durch die vorerwähnten Randausbrüche 27 der Haube 20 ins Kasteninnere eingeführt. Im äußersten Endbereich des Kabels 30, das sich im Montagefall im Kasteninneren befindet, ist schließlich auch der Kabelschirm 32 entfernt. Dort liegen die einzelnen Adern 33 des Kabels 30 für ihre weitere noch näher zu beschreibende Kontaktierung frei. Außer diesen miteinander verseilten Adern 33 besitzt das Kabel aber auch noch einen im wesentlichen längsverlaufenden Beidraht 34, der blank ausgebildet ist und zur durchgehenden Längskontaktierung des Kabelschirms 32 dient.

Zur Festlegung des Kabels 30 dient zunächst der Basisschenkel 12. Dort sind, paarweise für jedes Kabel 30, sowohl eine Abfangstelle 28 als auch eine Erdungsklemme 29 vorgesehen. Zur Ausbildung der Abfangstelle 28 ist der Basisschenkel 12 in seiner äußeren Randzone mit einer Schar von in einer Reihe angeordneten Ausstanzungen 35 versehen, die ein aus dem Blech gebildetes T-Stück umschließen. Dieses T-Stück 36 wird im Montagefall von einem die Kabel 30 umgreifenden Befestigungsband 37 umgriffen.

Für die Ausbildung der Erdungsklemmen 29 ist der Basisschenkel 12, in Abstand zu den Ausstanzungen 35 mit einer Reihe von Löchern 38 versehen, die jeweils zur Montage von U-förmigen Klemmbügeln 39 dienen. Die Klemmbügel 39 umgreifen einzeln oder paarweise die Kabel 30, und zwar an ihren mit freiliegenden Kabelschirmen 32 versehenen Bereichen. Über die Klemmen 39 werden die Kabelschirme 32 an die bereits erwähnte Kontaktinnenfläche 16 des Basisschenkels 12 angedrückt. Für eine Erdung sämtlicher, auf diese Weise kontaktierter Kabelschirme 32 besitzt der Basisschenkel 12 auch noch einen aus Fig. 1 ersichtlichen Erdungspunkt 49, der aus einem aufgeschweißten Gewindestift mit Muttern und Kontaktscheiben besteht.

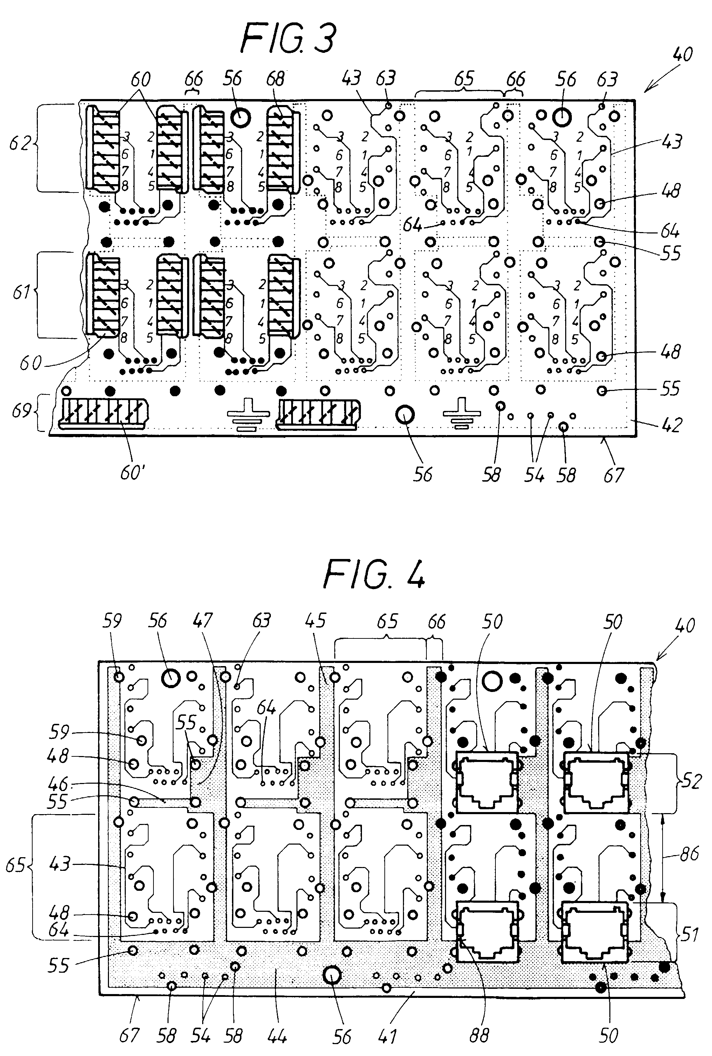

Ein wesentlicher Bestandteil des Frontabschlusses ist eine aus Fig. 1, 2 und 5 ersichtliche Leiterplatte 40, deren Aufbau in Fig. 3 und 4 näher gezeigt ist. Die Leiterplatte 40 ist in parallelem Abstand 78 zu der Kontaktinnenfläche 17 des Frontschenkels 11 angeordnet und dient als Träger von Buchsen 50 einerseits und zwei Sorten von Anschlußblöcken 60, 60' andererseits. Die Buchsen 50 befinden sich auf der im Montagefall dem Frontschenkel 11 zugekehrten Plattenvorderseite 41, während die Anschlußblöcke 60, 60' auf der Plattenrückseite 42 angeordnet sind. Wie am besten aus Fig. 4 zu entnehmen ist, sind die Buchsen 50 in zwei in Abstand 86 zueinander liegenden parallelen Reihen 51, 52 an der Leiterplatte 40 befestigt, wofür mit Erdbahnen 44 bzw. 46 verbundene, zugleich der elektrischen Kontaktierung von Erdungsstiften dienende Kontaktdurchbrüche 55 in der Leiterplatte vorgesehen sind. Die Leiterplatte besitzt aber auch lediglich zur mechanischen Festlegung der Buchse 50 dienende Verbindungsdurchbrüche 48. Jede Buchse 50 ist mit in Fig. 2 und 5 punktschraffiert angedeuteten Außenabschirmungen 53 versehen, an denen die Erdungsstifte sitzen. Mindestens zwei dieser Erdungsstifte pro Buchse 50 durchgreifen zwei Kontaktdurchbrüche 55 und sind mit den zugehörigen Erdbahnen 44, 46 verbunden.

Auch die Anschlußblöcke 60 sind, wie die Rückansicht 42 der Leiterplatte 40 in Fig. 3 zeigt, auch in zwei parallelen Reihen 61, 62 angeordnet, die aber, wie die Seitenansicht von Fig. 2 lehrt, im Höhenversatz zueinander angeordnet sind. Für die mechanische Anbringung der aus Kunststoff bestehenden Anschlußblöcke 60 dienen Plattendurchbrüche 59. Die elektrische Kontaktierung erfolgt über gesonderte Kontaktdurchbrüche 63 durchgreifende Anschlußstifte dieser Blöcke 60. Diese Kontaktdurchbrüche 63 sind über vorder- und rückseitige Leiterbahnen 43 gemäß Fig. 3 und 4 mit weiteren zur Durchführung von Anschlußstiften dienenden Kontaktdurchbrüchen 64 für die zugehörige Buchse 50 verbunden. Die Anschlußblöcke 60 sind mit abisolierfreien, am besten aus Fig. 3 erkennbaren, Kontakten 68 versehen und dienen zum Anschluß der bereits im Zusammenhang mit Fig. 1 und 2 beschriebenen Adern 33 des ankommenden Kabels 30. Zu den acht Adern eines solchen Kabels 30 gehören jeweils ein Paar gleichartiger Anschlußblöcke 60, die ein in Fig. 3 mit 65 gekennzeichnetes Feld 65 beidseitig begrenzen. Die Kontaktdurchbrüche 63 für die Anschlußstifte der Anschlußblöcke 60 sind durch aufgedruckte Ziffern 1 bis 8 in Fig. 3 näher gekennzeichnet. In jedem dieser Felder 65 sind sämtliche Leiterbahnen 43 angeordnet, die zu einem solchen Anschlußblock-Paar 60 einerseits und der zugehörigen Buchse 50 andererseits gehören. Ein solches Feld 65 befindet sich, entsprechend der Anzahl der Buchsen 50, im Höhenbereich jeder der beiden Anschlußblock-Reihen 61 bzw. 62. Im unteren Bereich eines jeden Feldes 65, zur unteren Plattenkante 67 hin, befinden sich die erwähnten Kontaktdurchbrüche 64 für die Anschlußstifte der zugehörigen Buchse 50. Zwischen benachbarten Feldern 65 liegen freie Zonen 66, die von der oberen bis zur unteren Plattenkante 67 durchgehen. Auf der Plattenrückseite 42 befinden sich beidseitig dieser Zone 66 jeweils die Anschlußblöcke 60 zweier, zu benachbarten Kabeln 30 gehörenden Blockpaare.

Alle Erdbahnen der Leiterplatte 40 sind in der aus Fig. 4 ersichtlichen Vorderansicht 41 durch Punktschraffur hervorgehoben, deren Lage in der Rückansicht 42 in Fig. 3 durch Punktumrisse verdeutlicht ist. Dazu gehört zunächst ein im wesentlichen parallel zur unteren Plattenlängskante 67 verlaufender breiter stromtragfähiger Streifen 44, der nachfolgend kurz "Erdbahnstreifen" benannt werden soll. Von diesem gehen, quer dazu, eine Schar von schmalen Streifen 45 astartig ab, weshalb diese nachfolgend kurz "Erdbahnäste" bezeichnet werden sollen. Diese Erdbahnäste 45 sind wiederum Ausgangspunkt für eine davon abgezweigte, demgegenüber noch schmaler ausgebildete Erdbahn 46, die nachfolgend sinngemäß als "Erdbahnzweig" bezeichnet werden soll. Im Übergangsbereich zwischen einem Erdbahnast 45 und einem Erdbahnzweig 46 befindet sich eine Verbreiterung 47 der Erdbahn. Diese im wesentlichen rechtwinkelig zueinander verlaufenden Erdbahnzweige 46, Erdbahnäste 45 und der gemeinsame breite Erdbahnstreifen 44 erzeugen in der Leiterplatte 40 ein koordinatenförmiges Netz von Erdbahnen, welches die zu der unteren Buchsen-Reihe 51 gehörende untere Reihe von Feldern 65 der einzelnen zusammengehörigen Leiterbahnen 43 feldweise nahezu vollständig rahmenartig umschließt. Aber auch die obere Reihe von Feldern 65, die zu den einzelnen Buchsen 50 der oberen Buchsen-Reihe 52 gehören, sind dreiseitig rahmenartig von einem benachbarten Paar von Erdbahnästen 45 einerseits und einem zwischen diesen verlaufenden Erdbahnzweig 46 andererseits umgrenzt. Auf der zunächst freien oberen Seite liegt aber im Montagefall, gemäß Fig. 2, der Deckschenkel 13 des Blechs 10. Damit sind alle Anschlußstellen 63, 64 zusammengehöriger Anschlußblock-Paare 60 und Buchsen 50 zusammen mit den dazwischen verlaufenden Leiterbahnen feldweise gegeneinander abgeschirmt, wodurch die Nebensprechdämpfung des erfindungsgemäßen Frontabschlusses maßgeblich verbessert ist.

Die zur elektrischen Kontaktierung von Kontaktstiften dienenden Kontaktdurchbrüche 55 der unteren Anschlußblock-Reihe 61 sind jeweils paarweise in den breiten Erdbahnstreifen 44 integriert. Die entsprechenden Kontaktdurchbrüche 55 für die obere Anschlußblock-Reihe 62 sind in zwei Exemplaren in dem dortigen Erdbahnzweig 46 und einem dritten Exemplar 55 in der beschriebenen Erdbahn-Verbreiterung 47 angeordnet. Die Kontaktdurchbrüche 55 für die einzelnen Buchsen 50 bilden eine erste Erdkontaktierung für die Außenabschirmung 53, die, wie bereits erwähnt wurde, einer jeden Buchse 50 zugeordnet und in Fig. 2 durch Punktschraffur hervorgehoben ist. Die Erfindung besitzt aber noch eine besondere zweite Erdkontaktierung bei 70, die noch näher beschrieben werden soll.

Die bereits oben erwähnte andere Sorte von Anschlußblöcken 60', die an sich auch abisolierfreie Schneidkontakte aufweist, dient zum Anschluß der bereits erwähnten blanken Kabel-Beidrähte 34 beider paarweise ankommenden Kabel 30, wie am besten aus Fig. 1 und 2 zu erkennen ist. Für die elektrischen Stifte dieser Anschlußblöcke 60' sind Kontaktdurchbrüche 54 im Bereich des stromtragfähigen Erdbahnstreifens 44 angeordnet, wie aus Fig. 4 hervorgeht. In diesem Bereich sind aber auch lediglich der mechanischen Verbindung dienende weitere Durchbrüche 58 für jeden dieser Anschlußblöcke 60' vorgesehen. Alle für den Beidraht 34 dienenden Anschlußblöcke 60' sind, ausweislich der Fig. 3, in einer gemeinsamen unteren Reihe 69 angeordnet und befinden sich in der der Plattenunterkante 67 benachbarten Randzone.

Eine solche vorderseitig mit Buchsen 50 und rückseitig mit Anschlußblöcken 60 und 60' ausgerüstete, vormontierte Leiterplatte 40 wird nun, wie anhand der Fig. 5 näher erläutert wird, auf besondere Weise an dem Frontschenkel 11 befestigt. Dazu dienen aus leitendem Material bestehende Abstandhalter 71, die im vorliegenden Fall aus einer Gewindehülse bestehen. Diese Gewindehülse 71 ist mit ihrem einen Hülsenende 72, wie aus Fig. 5 zu erkennen ist, an der eingangs erwähnten Kontaktinnenfläche 17 befestigt, und zwar durch Schweißen oder Löten. Das gegenüberliegende Stirnende 73 kommt im Montagefall an der Leiterplatte 40 zur Anlage, die, wie aus Fig. 5 am besten zu entnehmen ist, an dieser Stelle ein Plattenbefestigungsloch 56 aufweist. Eine Schar dieser Plattenbefestigungslöcher befindet sich, wie auch die Draufsicht von Fig. 4 zeigt, im Bereich einer Erdbahn, nämlich des vorbeschriebenen breiten Erdbahnstreifens 44. Wie allgemein üblich, ist die mit den Leiter- und Erdbahnen 43 bis 46 ausgerüstete Plattenvorder- und Rückseite 41, 42 mit einer isolierenden Schutzschicht versehen, doch im Bereich des vorerwähnten Plattenbefestigungslochs 56 liegt eine Kontaktstelle 57 blank. Diese Kontaktstelle soll zur Unterscheidung von einer entsprechenden, auf der Plattenrückseite 42 befindlichen weiteren Kontaktstelle 77, nachfolgend als "Vorderkontaktstelle" bezeichnet werden. Demgemäß wird die rückseitige Kontaktstelle 77 "Rückkontaktstelle" genannt. Diese Vorder- und Rückkontaktstellen 57, 77 bestehen aus den Stirnflächen eines die Leiterplatte 40 durchdringenden Kontaktringes, der mit dem Erdbahnstreifen 44 elektrisch leitend verbunden ist und dessen Ringöffnung das Plattenbefestigungsloch 56 bestimmt.

Zur Befestigung der mit den Bauelementen 50, 60, 60' vormontierten Leiterplatte 40 an den Gewindehülsen 71 des Frontschenkels 11 verwendet man die aus der Explosionsdarstellung von Fig. 5 erkennbaren Befestigungsschrauben 74, die im Montagefall in Gewindeeingriff mit dem im Ausbruch von Fig. 5 erkennbaren Innengewinde 76 der Gewindehülse 71 treten. Im Montagefall kommt dann ein an der Befestigungsschraube 74 vorgesehener Schraubenkopf 75 zur Anlage mit der bereits erwähnten ringförmigen Rückkontaktstelle 77, welche das von der Befestigungsschraube 74 durchsetzte Plattenbefestigungsloch 56 ringförmig umschließt. Die Abstandhalter 71 sind im oberen und unteren Plattenrand im Wechsel angeordnet, wie am besten aus der Anordnung der Löcher 56 in Fig. 3 und 4 zu ersehen ist. Die Abstandhalter 71 erfüllen somit eine dreifache Aufgabe. Die erste Aufgabe der Gewindehülsen 71 besteht darin, im Montagefall für den aus Fig. 2 ersichtlichen definierten Abstand 78 zwischen dem Frontschenkel 11 einerseits und der bestückten Leiterplatte 40 andererseits zu sorgen. Dies wird durch die Länge der Gewindehülsen 71 bestimmt. Im Montagefall ragen die an der Leiterplatte 40 vorderseitig befestigten Buchsen 50 in entsprechende, aus Fig. 5 am besten ersichtliche Fenster 79 hinein, wo sie mit ihren am besten aus Fig. 4 ersichtlichen, stirnseitigen Buchsenöffnungen 88 im wesentlichen bündig mit der Außenfläche des Frontschenkels 11 zu liegen kommen. Die Buchse 50 ist als ein sogenannter Modular-Jack ausgebildet und dient zur Kontaktierung von nicht näher gezeigten Steckern, die mit abgehenden elektrischen Kabeln bzw. Leitungen versehen sind.

Die zweite Aufgabe der Abstandhalter 71 besteht darin, die mit den Bauelementen 50, 60, 60' bestückte Leiterplatte 40 am Frontschenkel 11 zu befestigen. Dafür sorgt der beschriebene Gewindeeingriff der die Platte 40 durchsetzenden Befestigungsschrauben 74 im Innengewinde 76 der Abstandhalter 71. Schließlich erfüllen die elektrisch leitenden Abstandhalter 71 die dritte Aufgabe einer guten Durchverbindung zwischen den Erdbahnen 44 bis 47 der Leiterplatte 40 einerseits und dem über den Basisschenkel 12 geerdeten Frontschenkel 11 andererseits. Die vorbeschriebenen Vorderkontaktstellen 57 sind über die Befestigungsschrauben 74 in Andruck an den Stirnenden 73 des zugehörigen Abstandhalters 71.

Zur oben erwähnten zweiten Erdkontaktierung 70 der an den einzelnen Buchsen 50 vorgesehenen, in Fig. 2 und 5 durch Punktschraffur hervorgehobenen Außenabschirmung 53 gehören besondere Kontaktglieder 80, die unmittelbar an der Kontaktinnenfläche 17 der Frontschenkel 11 befestigt sind. Diese Kontaktglieder 80 umfassen vorzugsweise ein U-Profil und sind zweckmäßigerweise als eine durchgehende U-Profilschiene ausgebildet. Die U-Profilschiene 80 besteht aus leitendem Material und ist mit ihrem U-Mittelsteg 81 im Montagefall in Anlage mit dem Frontschenkel 11. Dazu dienen an der Kontaktinnenfläche 17 festgeschweißte Gewindestifte 83, die einen Durchbruch im Schienen-Mittelsteg 81 durchsetzen und zum Aufschrauben von aus Fig. 5 ersichtlichen Muttern 84 dienen. Die Muttern 84 drücken den Schienenmittelsteg 81 an die Kontaktfläche 17 des Frontschenkels 11 an. Dabei kommen die beiden U-Seitenstege 82 der Schiene 80 unmittelbar mit der Außenabschirmung 83 benachbarter Buchsen 50 in Berührung.

Die U-Schiene 80 verläuft parallel zu der auch in Fig. 5 erkennbaren unteren Knickkante 14 des Blechs 10 und besitzen eine aus Fig. 5 erkennbare Schienenbreite 85, die größer/gleich dem aus Fig. 2 entnehmbaren Höhenabstand 86 zwischen den beiden übereinanderliegenden parallelen Reihen 51, 52 der Buchsen 50 ist. Anstelle der einstückigen U-Schiene 80 könnte das Kontaktglied auch aus einzelnen Kontaktbügeln bestehen, die, wenn sie U-Form haben, jeweils nur ein Paar benachbarte Buchsen 50 kontaktieren. Es könnte sich in diesem Fall auch um Buchsen 50 handeln, die nicht in übereinanderliegenden Buchsen-Reihen 51, 52 angeordnet sind, sondern in einer gemeinsamen Reihe 51 oder 52 nebeneinander liegen. Ferner wäre es denkbar, das Kontaktglied insoweit zu vereinfachen, daß anstelle eines U-Profils nur ein L-Profil mit lediglich einem einzelnen Seitensteg 82 vorliegt. Dieser kontaktiert dann nur die Außenabschirmung 53 einer einzelnen Buchse 50, während für die anderen Buchsen eigene analoge Kontaktglieder vorgesehen sind. Maßgeblich ist, daß mittels eines oder mehrerer solcher Kontaktglieder 80 die Außenabschirmungen 53 sämtlicher Buchsen 50 auf einem gemeinsamen Potential liegen.

Nach Befestigung der bestückten Leiterplatte 40 am Frontschenkel 11 und dem Anschluß der diversen Kabel-Adern 33 und Kabel-Beidrähte 34 an die Anschlußblöcke 60 bzw. 60' wird die bereits eingangs beschriebene Schutzhaube 20 montiert. Dabei ergeben sich die aus Fig. 6 ersichtlichen Verhältnisse. Die Schutzhaube 20 geht vom Frontschenkel 11 aus und ihre Haubenhinterwand 21 trifft auf den Basisschenkel 12 in jener Zone 87, die, in Verlaufsrichtung des ankommenden Kabels 30 gesehen, hinter der Kabelklemme 39 liegt. Die Haubenhinterwand 21 trifft mit ihren aus Fig. 7 ersichtlichen Randausbrüchen 27 auf den Kabelschirm 32 im Abstandsbereich zwischen der Kabelklemme 39 und der bestückten Leiterplatte 40.

## Patentansprüche

1. Frontabschluß für elektrische Schränke, Gehäuse, Gestelle od. dgl.,
aus einem wenigstens L-förmig abgewinkelten Blech (10) mit einem Frontschenkel (11) und mit einem über die Knickkante (14) damit einstückigen Basisschenkel (12),
aus einer im wesentlichen in Parallelabstand (78) hinter dem Frontschenkel (11) verlaufenden Leiterplatte (40), die vorderseitig (41) in parallelen Reihen (51, 52) angeordnete Buchsen (50) für damit zu kontaktierende Stecker und rückseitig (42) Anschlußblöcke (60, 60') trägt,
welche (60) entweder über Leiterbahnen (43) auf der Leiterplatte (40) mit den vorderseitigen Buchsen (50) verbunden sind und für den Anschluß der diversen Adern (33) von ankommenden Kabeln (30) dienen,
oder (60') mit Erdbahnen (44) auf der Leiterplatte (40) verbunden sind und jeweils für den Anschluß von mit dem Kabelschirm (32) der ankommenden Kabel (30) kontaktierten Kabel-Beidrähten (34) bestimmt sind,
die Buchsen (50) mit ihren stirnseitigen, zum Einkuppeln der Stecker dienenden Buchsenöffnungen (88) in Fenstern (79) des Frontschenkels (11) sitzen und eine Buchsen-Außenabschirmung (53) aufweisen, die mit den Erdbahnen (44, 46) der Leiterplatte (40) verbunden sind,
der Basisschenkel (12) einen Erdungspunkt (49) besitzt und für jedes ankommende Kabel (30) sowohl eine Abfangstelle (28) als auch eine Erdungsklemme (29) für den Kabelschirm (32) aufweist,
**dadurch gekennzeichnet**,
daß ein Kontaktglied (80) mit vorzugsweise U-Profil (81, 82) im Abstandsbereich (86) zwischen zwei benachbarten Buchsen (50) angeordnet ist und die einander zugekehrten Innenflächen des Front-und Basisschenkels (11, 12) wenigstens bereichsweise blanke, elektrisch leitende Kontaktinnenflächen (17, 16) aufweisen,
das Kontaktglied (80) mit seinem U-Mittelsteg (81) an der Kontaktinnenfläche (17) des Frontschenkels (11) anliegt und mit seinen U-Seitenstegen (82) unmittelbar die Außenabschirmung (53) der benachbarten Buchsen (50) leitend berührt,
daß die Leiterplatte (40) über leitende Abstandhalter (71) mit dem Frontschenkel (11) verbunden ist,
der Abstandhalter (71) mit seinem einen Stirnende (72) an der Kontaktinnenfläche (17) des Frontschenkels (11) sitzt und mit seinem gegenüberliegenden anderen Stirnende (73) eine auf der Vorderseite (41) der Leiterplatte befindliche Vorderkontaktstelle (57) berührt
und diese Vorderkontaktstelle (57) Bestandteil derjenigen Erdbahn (44) der Leiterplatte (40) ist, mit der auch die Anschlußblöcke (60') für die Kabel-Beidrähte (34) verbunden sind,
und daß eine elektrisch leitende Schutzhaube (20) den Winkelbereich zwischen dem Front- und Basisschenkel (11, 12) in Abstand überbrückt, wobei die Schutzhaube (20) mit ihrer Haubenoberwand (22) die bestückte Leiterplatte (40) übergreift, mit beidendigen Haubenseitenwänden (23) die in Abstand am Frontschenkel (11) befestigte Leiterplatte (40) seitlich abschirmt und mit ihrer Haubenhinterwand (21) die auf der Rückseite (42) befindlichen Anschlußblöcke (60, 60') überdeckt.

2. Frontabschluß nach Anspruch 1, dadurch gekennzeichnet, daß das Kontaktglied aus einer durchgehenden U-Profilschiene (80) besteht, die am Frontschenkel (11) befestigt ist, im wesentlichen parallel zur Knickkante (14) des Blechs (10) verläuft und deren SchienenBreite (85) dem Höhenabstand (86) zwischen zwei parallelen Reihen (51, 52) von Buchsen (50) entspricht.

3. Frontabschluß nach Anspruch 2, dadurch gekennzeichnet, daß die U-Profilschiene (80) mit ihrem Schienen-Mittelsteg (81) von Gewindestiften (83) durchsetzt ist, die Gewindestifte (83) an der Kontaktinnenfläche (17) des Frontschenkels (11) festsitzen und zum Aufschrauben von Muttern (84) dienen, die im Montagefall den Schienen-Mittelsteg (81) an die Kontaktfläche (17) des Frontschenkels (11) andrücken.

4. Frontabschluß nach einem oder mehreren der Ansprüche 1 bis 3, dadurch gekennzeichnet, daß die Abstandhalter aus Gewindehülsen (71) bestehen, die mit ihrem einen Hülsenende (72) an der Kontaktinnenfläche (17) des Frontschenkels (11) befestigt sind und für den Gewindeeingriff (76) von Befestigungsschrauben (74) dienen, die von der Rückseite (42) der Leiterplatte (40) aus durch Plattenbefestigungslöcher (56) im Montagefall hindurchgeführt sind.

5. Frontabschluß nach Anspruch 4, dadurch gekennzeichnet, daß die Vorderkontaktstellen (57) für die Abstandhalter (71) die Plattenbefestigungslöcher (56) auf der Vorderseite (41) der Leiterplatte (40) ringförmig umschließen.

6. Frontabschluß nach Anspruch 4 oder 5, dadurch gekennzeichnet, daß das Plattenbefestigungsloch (56) auf der Rückseite (42) der Leiterplatte (40) von einer vorzugsweise ringförmigen Rückkontaktstelle (77) umschlossen ist, die im Montagefall zur Anlage eines an der Befestigunssschraube (74) befindlichen Schraubenkopfes (75) dient.

7. Frontabschluß nach einem oder mehreren der Ansprüche 1 bis 6, dadurch gekennzeichnet, daß die Erdbahnen in der Leiterplatte (40) einen breiten, stromtragfähigen Streifen (Erdbahnstreifen 44) aufweisen, der parallel zu einer Kante (67) der Leiterplatte (40) verläuft, der Erdbahnstreifen (44) sowohl zur Befestigung der rückseitigen Anschlußblöcke (60') für die Kabel-Beidrähte (34) als auch wenigstens teilweise für die eine vorderseitige Reihe (61) von Buchsen (60) dient und der Erdbahnstreifen (44) die Vorderkontaktstellen (57) für die Abstandhalter (71) sowie ggf. Rückkontaktstellen (77) für die zugehörigen Befestigungsschrauben (74) trägt.

8. Frontabschluß nach Anspruch 7, dadurch gekennzeichnet, daß der breite Erdbahnstreifen (44) im Montagefall der Leiterplatte (40) parallel zur Knickkante (14) zwischen dem Front- und Basisschenkel (11, 12) verläuft.

9. Frontabschluß nach einem oder mehreren der Ansprüche 1 bis 8, dadurch gekennzeichnet, daß die Erdbahnen (44 bis 47) diejenigen Felder (65) der Leiterplatte (40) wenigstens teilweise rahmenartig umschließen, welche zusammengehörige Leiterbahnen (43) mit ihren Anschlußstellen (63, 64) zwischen einer einzelnen Buchse (50) und den ihnen zugeordneten Anschlußblöcken (Anschlußblock-Paar 60) aufweisen.

10. Frontabschluß nach Anspruch 9, dadurch gekennzeichnet, daß die rahmenartig verlaufenden Erdbahnen (44 bis 47) ein koordinatenförmiges Bahnen-Netz bilden, das aus dem kantenparallelen breiten Erdbahnstreifen (44) einerseits und einer Schar von davon ausgehenden schmalen Erdbahnästen (45) andererseits besteht, wobei die Erdbahnäste (45) jeweils in der freien Zone (66) zwischen zwei in einer Reihe (61 oder 62) benachbarten Buchsen (50) verlaufen, (vergl. Fig. 4).

11. Frontabschluß nach Anspruch 10, dadurch gekennzeichnet, daß die Erdbahnäste (45) im Bereich der in einer höhenversetzten Reihe (62) gegenüber der Lage des Erdbahnstreifens (44) angeordneten Buchsen (50) mit davon abgehenden, weiteren schmalen Erdbahnzweigen (46) versehen sind, (vergl. Fig. 4).

12. Frontabschluß nach Anspruch 11, dadurch gekennzeichnet, daß sowohl die Erdbahnäste (45) als auch die Erdbahnzweige (46) zwar im wesentlichen linear verlaufen, aber an Ihrem Übergang Erdbahnverbreiterungen (47) für weitere Anschlußstellen (55) der Außenabschirmung (53) aufweisen, (vergl. Fig. 4).

13. Frontabschluß nach Anspruch 1, dadurch gekennzeichnet, daß die Haubenhinterwand (21) der Schutzhaube (20) im Montagefall am Basisschenkel (12) in der Zone (87) zwischen der Leiterplatte (40) einerseits und den Erdungsklemmen (29) für die Kabelschirme (32) der ankommenden Kabel (30) andererseits angeordnet ist.

14. Frontabschluß nach einem oder mehreren der Ansprüche 1 bis 13, dadurch gekennzeichnet, daß das Blech (10) U-förmig abgewinkelt ist, außer dem durch eine erste Knickkante (14) bestimmten Front-und Basisschenkel (11, 12) einen durch eine weitere, vorzugsweise zur ersten Knickkante (14) parallele Knickkante (15) abgesetzten, dem Basisschenkel (12) gegenüberliegenden Deckschenkel (13) aufweist, der oberhalb der Leiterplatte (40) verläuft.

15. Frontabschluß nach Anspruch 14, dadurch gekennzeichnet, daß der Deckschenkel (13) im Montagefall die Haubenoberwand (22) der Schutzhaube (20) übergreift und die Haubenoberwand (22) in einer freien Lücke (26) zwischen der Oberkante der Leiterplatte (40) und dem Deckschenkel (13) angeordnet ist.

## Claims

1. A front closure for electrical cabinets, housings, rack assemblies or the like, comprising
a plate (10) which is of an at least L-shaped angled configuration with a front limb (11) and a base limb (12) which is in one piece therewith by way of the bend edge (14), and
a printed circuit board (40) which extends substantially at a parallel spacing (78) behind the front limb (11) and which at the front side (41) carries sockets (50) arranged in parallel rows (51, 52) for plugs to be contacted therewith and at the rear side (42) connecting blocks (60, 60') which (60) are either connected by way of conductor tracks (43) on the printed circuit board (40) to the sockets (50) at the front side and serve for the connection of the various wires (33) of arriving cables (30)
or (60') are connected to earth tracks (44) on the printed circuit board (40) and which are respectively intended for the connection of cable supplementary earth wires (34) which are contacted with the cable screening (32) of the arriving cables (30),
the sockets are carried with their end socket openings (88) which serve for coupling in the plugs in windows (79) in th front limb (11) and have a socket outer screening (53), which are connected to the earth tracks (44, 46) of the printed circuit board (40), and
the base limb (12) has an earthing point (49) and for each arriving cable (30) has both a bracing location (28) and also an earthing clamp (29) for the cable screening (32),
characterised in that
a contact member (80) of preferably U-shaped profile (81, 82) is arranged in the spacing region (86) between two adjacent sockets (50) and the inside surfaces, which are towards each other, of the front and base limbs (11, 12) have electrically conductive contact inside surfaces (17, 16) which are bare at least in a region-wise manner,
the contact member (80) bears with the central web portion (81) of its U-shape against the contact inside surface (17) of the front limb (11) and with the side web portions (82) of its U-shape is directly in conductive contact with the outer screening (53) of the adjacent sockets (50),
the printed circuit board (40) is connected to the front limb (11) by way of conductive spacers (71),
the spacer (71) fits with its one end (72) to the contact inside surface (17) of the front limb (11) and with its oppositely disposed other end (73) touches a front contact location (57) which is on the front side (41) of the printed circuit board
and said front contact location (57) is a component of that earth track (44) of the printed circuit board (40), to which the connecting blocks (60') for the cable supplementary earth wires (34) are also connected,
and an electrically conductive protective cover (20) bridges over at a spacing the angular region between the front and base limbs (11, 12), wherein the protective cover (20) engages with its upper wall (22) over the equipped printed circuit board (40), laterally screens with cover side walls (23) at both ends the printed circuit board (40) which is fixed at a spacing to the front limb (11), and with its rear wall (21) covers over the connecting blocks (60, 60') which are on the rear side (42).

2. A front closure according to claim 1 characterised in that the contact member comprises a continuous U-shaped bar (80) which is fixed to the front limb (11) and which extends substantially parallel to the bend edge (14) of the plate (10) and whose width (85) corresponds to the heightwise spacing (86) between two parallel rows (51, 52) of sockets (50).

3. A front closure according to claim 2 characterised in that screwthreaded pins (83) pass through the U-shaped bar (80) in the central web portion (81) thereof, the screwthreaded pins (83) are fixed to the contact inside surface (17) of the front limb (11) and serve to screw on nuts (84) which upon assembly press the central web portion (81) of the bar against the contact surface (17) of the front limb (11).

4. A front closure according to one or more of claims 1 to 3 characterised in that the spacers comprise screwthreaded sleeves (71) which are secured with their one sleeve end (72) to the contact inside surface (17) of the front limb (11) and serve for the screwthreaded engagement (76) of fixing screws (74) which are passed from the rear side (42) of the printed circuit board (40) through board fixing holes (56) upon assembly.

5. A front closure according to claim 4 characterised in that the front contact locations (57) for the spacers (71) extend in an annular configuration around the board fixing holes (56) on the front side (41) of the printed circuit board (40).

6. A front closure according to claim 4 or claim 5 characterised in that the board fixing hole (56) is surrounded on the rear side (42) of the printed circuit board (40) by a preferably annular rear contact location (77) which upon assembly serves for contact with a screw head (65) on the fixing screw (74).

7. A front closure according to one or more of claims 1 to 6 characterised in that the earth tracks in the printed circuit board (40) have a wide strip capable of carrying current (earth track strip 44) which extends parallel to an edge (67) of the printed circuit board (40), the earth track strip (44) serves both for fixing the rear-side connecting blocks (60') for the cable supplementary earth wires (34) and also at least in part for the one front-side row (61) of sockets (60) and the earth track strip (44) carries the front contact locations (57) for the spacers (71) and possibly rear contact locations (77) for the associated fixing screws (74).

8. A front closure according to claim 7 characterised in that upon assembly of the printed circuit board (40) the wide earth track strip (44) extends parallel to the bend edge (14) between the front and base limbs (11, 12).

9. A front closure according to one or more of claims 1 to 8 characterised in that the earth tracks (44 to 47) extend at least partly in a frame-like configuration around those areas (65) of the printed circuit board (40), which have associated conductor tracks (43) with their connecting locations (63, 64) between an individual socket (50) and the connecting blocks associated with them (connecting block pair 60).

10. A front closure according to claim 9 characterised in that the earth tracks (44 to 47) which extend in a frame-like configuration form a track network in co-ordinate form which comprises the wide earth track strip (44) which is parallel to the edge on the one hand and an array of narrow earth track limbs (45) which are extend therefrom on the other hand, wherein the earth track limbs (45) each extend in the free zone (66) between two respective sockets (50) which are adjacent in a row (61 or 62) (see Figure 4).

11. A front closure according to claim 10 characterised in that in the region of the sockets (50) which are arranged in a row (60) which is displaced in respect of height relative to the position of the earth track strip (44), the earth track limbs (45) are provided with further narrow earth track branches (46) which extend therefrom (see Figure 4).

12. A front closure according to claim 11 characterised in that both the earth track limbs (45) and also the earth track branches (46) admittedly extend substantially linearly but at their transition they have increased-width earth track portions (47) for further connecting locations (55) of the outer screening (53) (see Figure 4).

13. A front closure according to claim 1 characterised in that the rear wall (21) of the protective cover (20) in the assembly situation is arranged on the base limb (12) in the zone (87) between the printed circuit board (40) on the one hand and the earthing clamps (29) for the cable screenings (32) of the arriving cables (30) on the other hand.

14. A front closure according to one or more of claims 1 to 13 characterised in that the plate (10) is of a U-shaped angled configuration, and besides the front and base limbs (11, 12) which are defined by a first bend edge (14) it has a cover limb (13) which is disposed in opposite relationship to the base limb (12) and which extends above the printed circuit board (40) and which is provided by virtue of a further bend edge (15) which is preferably parallel to the first bend edge (14).

15. A front closure according to claim 14 characterised in that upon assembly the cover limb (13) engages over the top wall (22) of the protective cover (20) and the top wall (22) of the cover is arranged in a free gap (26) between the upper edge of the printed circuit board (40) and the cover limb (13).

## Revendications

1. Fermeture frontale pour armoires électriques, boîtiers, châssis ou assimilés,
formée d'une tôle (10) au moins coudée en L comportant une branche frontale (11) et une branche de base monobloc (12) allant au-delà de l'arête coudée (14),
formée d'une carte à circuits imprimés (40) disposée essentiellement parallèle (78) derrière la branche frontale (11), laquelle (40) sert de support, sur son côté avant (41), à des prises (50) disposées en rangées parallèles (51, 52) et avec lesquelles (50) des fiches entrent en contact, et au dos (42) à des blocs de raccordement (60, 60'),
lesquels (60) soit sont reliés aux prises (50) situées côté avant par des circuits imprimés (43) sur la carte (40) et servent au raccordement des divers fils (33) provenant des câbles arrivants (30),
soit ils (60') sont reliés à des circuits de terre (44) situés sur la carte à circuits imprimés (40) et sont destinés chacun au raccordement des fils auxiliaires (34) connectés à la tresse de blindage (32) des câbles arrivants (30),
les orifices frontaux (88) des prises (50) servant à connecter les fiches reposent dans des fenêtres (79) ménagées dans la branche frontale (11) et les prises présentent un blindage extérieur (53) relié aux circuits de terre (44, 46) des cartes à circuits imprimés (40),
la branche de base (12) possède un point de jonction à la terre (49) et, pour chaque câble arrivant (30), présente aussi bien un point d'interception (28) qu'une bride de raccordement à la terre (29) du blindage (32) du câble,
**caractérisée en ce que**
un élément de contact (80) de préférence à profilé en U (81, 82) est disposé dans l'espace (86) entre deux prises voisines (50) et en ce que les surfaces intérieures se faisant face des branches frontales et de base (11, 12) présentent des surfaces-contact intérieures (17, 16) au moins localement à nu, électroconductrices,
l'élément-contact (80) applique par sa nervure médiane en U (81) contre la surface-contact intérieure (17) de la branche frontale (11) et touche directement, par ses nervures latérales en U (82), de manière électroconductrice, le blindage extérieur (53) des prises voisines (50),
la carte carte à circuits imprimés (40) est reliée à la branche frontale (11) par des écarteurs électroconducteurs (71),
l'écarteur (71) repose par une extrémité frontale (72) contre la surface-contact intérieure (17) de la branche frontale (11) et touche, par l'extrémité frontale opposée (73), un point-contact avant (57) situé sur le côté avant (41) de la carte à circuits imprimés,
en ce que ce point-contact avant (57) fait partie intégrante du circuit de terre (44) équipant la carte à circuits imprimés (40), à laquelle sont aussi reliés les blocs de raccordement (60') des fils auxiliaires (34) des câbles,
et en ce qu'un capot protecteur (20) électroconducteur ponte à une certaine distance la zone angulaire située entre les branches frontale et de base (11, 12), la paroi supérieure (22) du capot protecteur (20) dépasse la carte à circuits imprimés (40) garnie, protège latéralement, par ses parois latérales (23) aux deux extrémités, la carte à circuits imprimés (40) fixée à une certaine distance contre la branche frontale (11), et recouvre pas sa paroi arrière (21) les blocs de raccordement (60, 60') situés au dos (42).

2. Fermeture frontale selon la revendication 1, caractérisée en ce que l'élément-contact se compose d'un rail continu profilé en U (80) fixé contre la branche avant (11) et qui a un tracé essentiellement parallèle à l'arête du coude (14) de la tôle (10) et dont la largeur (85) correspond à l'écart en hauteur (86) entre deux rangées parallèles (51, 52) de prises (50).

3. Fermeture frontale selon la revendication 2, caractérisée en ce que la nervure médiane (81) du rail profilé en U (80) est traversée par des tiges filetées (83), en ce que les tiges filetées (83) sont fixées contre la surface-contact intérieure (17) de la branche frontale (11) et qu'elles servent à visser des écrous dessus (84) qui, lors du montage de la nervure médiane (81) viennent appliquer contre la surface-contact (17) de la branche frontale (11).

4. Fermeture frontale selon l'une ou plusieurs des revendications 1 à 3, caractérisée en ce que les écarteurs sont formés par des douilles taraudées (71) fixées par une extrémité (72) contre la surface-contact (17) de la branche frontale (11) et servent à l'engrènement du filet (76) de vis de fixation (74) qui en cas de montage arrivent par le dos (42) de la carte à circuits imprimés (40) en traversant des trous de fixation de plaque (56).

5. Fermeture frontale selon la revendication 4, caractérisée en ce que les points-contact avant (57) des écarteurs (71) ceinturent en forme d'anneau les trous (56) de fixation des plaques sur le côté avant (41) de la carte à circuits imprimés (40).

6. Fermeture frontale selon la revendication 4 ou 5, caractérisée en ce que le trou de fixation des plaques (56) au dos (42) de la carte à circuits imprimés (40) est ceinturé par un point-contact dorsal (77) de préférence annulaire qui sert en cas de montage à ce qu'une vis de fixation (74) vienne appliquer dessus par sa tête (75).

7. Fermeture frontale selon l'une ou plusieurs des revendications 1 à 6, caractérisée en ce que les circuits de terre équipant la carte à circuits imprimés (40) présentent une bande large pouvant transporter l'électricité (bande de jonction à la terre 44) et ayant un tracé parallèle à un bord (67) de la carte à circuits imprimés (40), en ce que cette bande de jonction à la terre (44) sert à fixer aussi bien les blocs de raccordement (60') dorsaux des fils auxiliaires (34) des câbles, qu'au moins en partie une rangée avant (61) de prises (60) et en ce que cette bande de jonction à la terre (44) supporte les points-contact avant (57) des écarteurs (71) ainsi que les points-contact dorsaux (77) destinés aux vis de fixation correspondantes (74).

8. Fermeture frontale selon la revendication 7, caractérisée en ce que la bande large (44) de jonction à la terre présente, en cas de montage de la carte à circuits imprimés (40), un tracé parallèle à l'arête (14) du coude entre les branches frontale et de base (11, 12).

9. Fermeture frontale selon l'une ou plusieurs des revendications 1 à 8, caractérisée en ce que les bandes de jonction à la terre (44 à 47) ceinturent au moins partiellement en forme de cadre les zones (65) de la carte (40) qui présentent des circuits imprimés (43) allant ensemble avec leurs points de branchement (63, 64) entre chaque prise (50) et les blocs de raccordement qui leur sont affectés (paire de blocs de branchement 60).

10. Fermeture frontale selon la revendication 9, caractérisée en ce que les bandes de jonctions à la terre (44 à 47) ayant un tracé en forme de cadre forment un réseau de circuits en forme de coordonnées, lequel réseau se compose d'une part de la bande large de jonction à la terre (44) parallèle au bord de carte, et d'autre part d'un grand nombre de branches étroites (45) de la bande de jonction à la terre qui en partent, ces branches (45) circulant chacune dans la zone libre (66) entre deux prises situées dans une rangée (61 ou 62) ou voisines (50) (cf. la fig. 4).

11. Fermeture frontale selon la revendication 10, caractérisée en ce que les branches (45) de la bande de jonction à la terre sont équipées d'autres ramifications étroites (46) dans la zone des prises (50) disposées en rangée décalée en hauteur (62) par rapport à la position du ruban de jonction à la terre (44) (cf. la fig. 4).

12. Fermeture frontale selon la revendication 11, caractérisée en ce qu'aussi bien les branches (45) que les ramifications (46) ont certes un tracé essentiellement linéaire, mais qu'elles présentent dans leur zone de transition un élargissement de bande (47) créant des points de branchement supplémentaires (55) pour le blindage extérieur (53) (cf. la fig. 4).

13. Fermeture frontale selon la revendication 1, caractérisée en ce que la paroi arrière (21) du capot protecteur (20) est disposée, en cas de montage contre la branche de base (12), dans la zone (87) située entre d'une part la carte à circuits imprimés (40) et d'autre part les bornes de raccordement à la terre (29) des tresses (32) blindant les câbles arrivants (30).

14. Fermeture frontale selon l'une ou plusieurs des revendications 1 à 13, caractérisée en ce que la tôle (10) est coudée en U, qu'elle présente outre une branche frontale et de base (11, 12) déterminée par une première arête coudée (14), une branche couvrante (13) décalée en hauteur par une arête coudée (15) au tracé de préférence parallèle à la première arête coudée (14) et faisant face à la branche de base (12), laquelle branche (13) se situe au-dessus de la carte à circuits imprimés (40).

15. Fermeture frontale selon la revendication 14, caractérisée en ce que la branche couvrante (13) dépasse, en cas de montage, la paroi supérieure (22) du capot de protection (20) et en ce que cette paroi supérieure (22) est disposée dans un espace libre (26) situé entre le bord supérieur de la carte à circuits imprimés (40) et la branche couvrante (13).
